# EUROPÄISCHE PATENTSCHRIFT

(11) **EP 3 449 291 B1**
(45) Veröffentlichungstag und Bekanntmachung des Hinweises auf die Patenterteilung: **16.09.2020**
(21) Anmeldenummer: 17714188.4
(22) Anmeldetag: 28.03.2017
(51) Int. Cl.: G02B 1/16, G21K 1/06, G02B 5/08, G03F 7/20

(54) **OPTISCHES ELEMENT UND OPTISCHE ANORDNUNG DAMIT**
OPTICAL ELEMENT AND OPTICAL ASSEMBLY COMPRISING SAME
ÉLÉMENT OPTIQUE ET SYSTÈME OPTIQUE COMPORTANT CET ÉLÉMENT

(30) Priorität: 28.04.2016 DE 102016207307
(43) Veröffentlichungstag der Anmeldung: 06.03.2019
(73) Patentinhaber: Carl Zeiss SMT GmbH, 73447 Oberkochen (DE)
(72) Erfinder: GRASSE, Christian, 85748 Garching (DE); DIER, Oliver, 73466 Lauchheim (DE); WEBER, Jörn, 73430 Aalen (DE); WINTER, Ralf, 73529 Schwäbisch Gmünd (DE)
(74) Vertreter: Kohler Schmid Möbus Patentanwälte
(86) Internationale Anmeldenummer: PCT/EP2017/057277
(87) Internationale Veröffentlichungsnummer: WO 2017/186439

(56) Entgegenhaltungen:
- WO-A1-2011/072953
- WO-A1-2011/073157
- WO-A2-2008/034582
- JP-A- 2007 194 406
- US-A1- 2008 153 010
- US-B2- 8 564 925

## Beschreibung

### Bezugnahme auf verwandte Anmeldung

Diese Anmeldung beansprucht die Priorität der deutschen Patentanmeldung DE 10 2016 207 307.9 vom 28. April 2016, deren gesamter Offenbarungsgehalt durch Bezugnahme zum Inhalt dieser Anmeldung gemacht wird.

### Hintergrund der Erfindung

Die Erfindung betrifft ein optisches Element, insbesondere für die EUV-Lithographie, umfassend: ein Substrat, eine auf das Substrat aufgebrachte reflektierende Beschichtung, sowie eine sich zwischen dem Substrat und der reflektierenden Beschichtung erstreckende elektrisch leitende Beschichtung. Die Erfindung betrifft auch eine optische Anordnung, insbesondere ein EUV-Lithographiesystem, mit mindestens einem solchen optischen Element.

Ein reflektives optisches Element wie weiter oben beschrieben ist aus der WO 2008/034582 A2 bekannt geworden. Durch die Bildung von Photoelektronen, insbesondere von Sekundärelektronen, bei der Bestrahlung des optischen Elements mit EUV-Strahlung werden an der der Umgebung zugewandten Oberfläche der reflektierenden Beschichtung Ladungen erzeugt, die typischer Weise nicht über das Substrat abgeführt werden können, da dieses entweder elektrisch isolierend ist oder im Vergleich zur reflektierenden Beschichtung, typischer Weise einer Mehrlagen-Beschichtung, eine wesentlich geringere elektrische Leitfähigkeit aufweist. Die dort beschriebene elektrisch leitende Beschichtung bzw. Schicht ist daher zur Erdung, zum Anlegen einer definierten Spannung oder zum Ableiten eines Photostroms elektrisch kontaktierbar.

Die elektrisch leitende Schicht kann elektrisch kontaktiert werden, um eine Erdung des optischen Elements vorzunehmen bzw. dieses mit einem definierten Potential zu verbinden. Auf diese Weise können die Ladungen von dem optischen Element abtransportiert werden und eine elektrostatische Aufladung des optischen Elements kann vermieden werden. Die von dem optischen Element abtransportierten Ladungen können auch dazu verwendet werden, einen Photostrom zu messen, mit dessen Hilfe Rückschlüsse auf den Kontaminationsgrad der reflektierenden Oberfläche des optischen Elements gezogen werden können.

In der WO 2008/034582 A2 wird vorgeschlagen, die elektrisch leitfähige Beschichtung aus einer einzelnen Schicht aus einem Metall zu bilden, beispielsweise aus Gold, Nickel, etc. oder aus Legierungen. Alternativ kann die elektrisch leitfähige Beschichtung auch aus einem (weiteren) Mehrlagen-System bestehen.

In der WO 2006/033442 A1 ist eine reflektive Maske beschrieben, bei der an der der reflektierenden Beschichtung abgewandten Rückseite des Substrats eine elektrisch leitfähige Schicht angebracht ist, um das Substrat zu erden und auf diese Weise das Substrat vor einer elektrostatischen Aufladung zu schützen. Eine weitere elektrisch leitfähige Schicht, welche die Schicht an der Rückseite des Substrats elektrisch leitend fortsetzt, bedeckt die Seitenflächen des Substrats sowie die Vorderseite des Substrats, an der unter anderem die reflektierende Beschichtung sowie eine strukturierte Absorberschicht aufgebracht sind.

In der JP 2007194406 A ist ein Spiegel mit einer reflektierenden Mehrlagen-Beschichtung beschrieben, der geeignet ist, die Mehrlagen-Beschichtung zu erden bzw. um an dem Spiegel ein elektrisches Potential anzulegen. Zu diesem Zweck wird eine elektrisch leitende Schicht zwischen die Mehrlagen-Beschichtung und das Substrat aufgebracht, die sich zu einer Halterung an der Seitenfläche des Spiegels erstreckt, an der eine Fassung für den Spiegel angebracht wird. Auf diese Weise kann die Mehrlagen-Beschichtung geerdet werden, ohne dass die reflektierende Oberfläche der Mehrlagen-Beschichtung beschädigt und die optischen Eigenschaften des Spiegels hierdurch beeinträchtigt werden.

### Aufgabe der Erfindung

Aufgabe der Erfindung ist es, ein optisches Element und eine optische Anordnung bereitzustellen, bei denen die optischen Eigenschaften des optischen Elements durch die elektrisch leitende Beschichtung nicht beeinträchtigt werden.

### Gegenstand der Erfindung

Diese Aufgabe wird gelöst durch ein optisches Element nach Anspruch 1, bei dem die elektrisch leitende Beschichtung mindestens eine erste, unter Zugspannung stehende Schicht und mindestens eine zweite, unter Druckspannung stehende Schicht aufweist.

Bei der Verwendung einer elektrisch leitenden Beschichtung in Form einer Einzelschicht aus einem hochleitenden, in der Regel metallischen Material, dessen Schichtdicke typischer Weise in der Größenordnung von z.B. hundert Nanometer oder darüber liegt, kann durch die Schichtspannung der elektrisch leitenden Beschichtung die Passe, d.h. die Oberflächenform des Substrats bzw. der reflektierenden Oberfläche der reflektierenden Beschichtung verändert werden, so dass es zu optischen Aberrationen kommen kann, welche die optischen Eigenschaften des Spiegels, insbesondere die Wellenfront der reflektierten EUV-Strahlung verschlechtern können oder die ggf. ein aufwändiges Korrekturverfahren erforderlich machen, um die Passe des Substrats bereits vor dem Aufbringen der elektrisch leitenden Beschichtung zu verändern. Hohe Schichtspannungen, beispielsweise in Form von Zugspannungen, treten insbesondere bei elektrisch leitenden Beschichtungen auf, die aus einem Edelmetall, z.B. aus Gold, bestehen, um eine möglichst hohe Leitfähigkeit und chemische Beständigkeit der elektrisch leitenden Beschichtung zu erzeugen.

Durch die Verwendung einer elektrisch leitenden Beschichtung mit einer ersten Schicht, die unter Zugspannung steht und einer zweiten Schicht, die unter Druckspannung steht, kann die Deformation des Substrats und damit der Oberflächenform des optischen Elements aufgrund von Schichtspannungen in der elektrisch leitenden Beschichtung reduziert werden. Zu diesem Zweck können das Material der (mindestens einen) ersten Schicht, die Dicke und ggf. die Art der Auftragung der ersten Schicht sowie das Material der (mindestens einen) zweiten Schicht, die Dicke und ggf. die Art der Auftragung der zweiten Schicht so gewählt werden, dass die Zugspannung der ersten Schicht die Druckspannung der zweiten Schicht im Wesentlichen kompensiert.

Eine solche Kompensation kann auf analoge Weise erfolgen wie in der US 8,564,925 B2 beschrieben ist, bei welcher eine elektrisch leitende Beschichtung eines Wafer-Chucks mindestens eine erste Schicht mit einer Zugspannung und mindestens eine zweite Schicht mit einer Druckspannung aufweist, die idealer Weise derart aufeinander abgestimmt sind, dass sich insgesamt Zug- und Druckspannungen kompensieren.

Alternativ zu einer (nahezu) vollständigen Kompensation der Schichtspannung ist es möglich, die Zugspannung und die Druckspannung der Schichten der elektrisch leitenden Beschichtung so aufeinander abzustimmen, dass eine gewünschte, vorgegebene resultierende Schichtspannung (Zug- oder Druckspannung) der elektrisch leitenden Beschichtung erzeugt wird. Die vorgegebene Schichtspannung der elektrisch leitenden Beschichtung kann beispielsweise derart gewählt werden, dass eine Schichtspannung, die aufgrund des Beschichtungsvorgangs in der reflektierenden Beschichtung entsteht, kompensiert oder ggf. weitestgehend kompensiert wird.

Bei einer Ausführungsform ist/sind die erste und/oder die zweite Schicht aus einem metallischen Material oder aus einer Legierung gebildet. Wie weiter oben beschrieben wurde, weisen metallische Materialien, insbesondere Edelmetalle, sowie ggf. deren Legierungen, eine hohe elektrische Leitfähigkeit und eine gute chemische Beständigkeit auf, so dass sich diese Materialien besonders gut für die elektrisch leitende Beschichtung eignen.

Folgende Gruppe von Materialien und ihre Legierungen sind aufgrund ihrer elektrischen Leitfähigkeit als Materialien für die erste und/oder die zweite Schicht der elektrisch leitfähigen Beschichtung besonders geeignet: Silber, Kupfer, Gold, Aluminium, Rhodium, Iridium, Wolfram, Molybdän, Cobalt, Nickel, Ruthenium, Indium, Osmium, Eisen, Platin, Palladium, Chrom, Tantal, Titan, Zr, Re.

Ob in der ersten und/oder der zweiten Schicht eine Druck- oder eine Zugspannung auftritt, lässt sich durch das jeweilige Herstellverfahren bzw. Beschichtungsverfahren beim Aufbringen der jeweiligen Schicht sowie durch das verwendete Schicht-Material beeinflussen. Mit anderen Worten gibt es Materialien, die eher zur Ausbildung von Zugspannungen neigen und Materialien, die eher zur Ausbildung von Druckspannungen neigen, wobei die Ausbildung einer Zug- oder Druckspannung durch das Herstellungsverfahren beeinflusst werden kann. Allgemein sind unter Herstellungsverfahren Beschichtungsverfahren in Form von "Physical Vapor Deposition"(PVD)-Verfahren zu verstehen wie z.B. thermisches Verdampfen oder Ebeam/Elektronenstrahl-Verdampfen, lonenstrahl- & Magnetronsputtern oder Pulsed Laser Deposition, oder Beschichtungsverfahren, die auf "Chemical Vapor Deposition" (CVD) beruhen.

Das Material der ersten Schicht kann beispielsweise ausgewählt sein aus obiger Gruppe und ist mit einem Beschichtungsverfahren hergestellt, das typischerweise Zugspannungen erzeugt. Beispielsweise kann die erste Schicht, welche die Zugspannung aufweist, aus Gold bestehen und mittels Elektronenstrahl-Verdampfen hergestellt sein.

Das Material der zweiten Schicht kann ebenfalls ausgewählt sein aus obiger Gruppe und bei der Beschichtung mit einem Verfahren aufgebracht werden, welches typischer Weise eine Druckspannung erzeugt. Beispielsweise kann die zweite Schicht aus Ruthenium gebildet sein und durch Sputtern aufgebracht werden, da dieses Beschichtungsverfahren typischer Weise eine Druckspannung erzeugt. Wie weiter oben beschrieben wurde, werden typischer Weise das Material der ersten Schicht und das Material der zweiten Schicht sowie die Schichtdicken so aufeinander abgestimmt, dass sich die gewünschte resultierende Schichtspannung der elektrisch leitenden Beschichtung einstellt, die insbesondere bei nahezu Null liegen kann. Es versteht sich, dass die resultierende Schichtspannung der elektrisch leitenden Beschichtung in der Regel nicht von der Reihenfolge der Schichten abhängig ist, d.h. die zweite Schicht, die eine Druckspannung aufweist, kann auf die erste Schicht aufgebracht werden, die eine Zugspannung aufweist, oder umgekehrt.

Bei einer weiteren Ausführungsform umfasst die elektrisch leitende Beschichtung mindestens eine Barriere-Schicht, die zwischen der ersten Schicht und der zweiten Schicht angeordnet ist. Die Barriere-Schicht ist ebenfalls aus einem elektrisch leitfähigen Material gebildet und soll die Diffusion des Materials der ersten Schicht in die zweite Schicht und umgekehrt verhindern. Weist die elektrisch leitende Beschichtung zwei oder mehr erste Schichten und zwei oder mehr zweite Schichten auf, so kann zwischen jeweils zwei benachbarten ersten und zweiten Schichten eine Barriere-Schicht gebildet sein. Da die Barriere-Schicht lediglich die Diffusion der Materialien zwischen der ersten und der zweiten Schicht unterbinden soll, kann die Barriere-Schicht sehr dünn sein und beispielsweise eine Dicke von weniger als z.B. ca. 1nm aufweisen, so dass die Leitfähigkeit der elektrisch leitfähigen Beschichtung nicht signifikant beeinträchtigt wird, auch wenn das Material der Barriere-Schicht nicht elektrisch leitfähig ist. Vorteil der Barriere-Schicht ist, dass eine Schichtdickenänderung aufgrund Diffusionsprozessen und somit eine Änderung der Oberflächenform (siehe oben) verhindert wird.

Bei einer weiteren Ausführungsform ist zwischen der reflektierenden Beschichtung und der elektrisch leitenden Beschichtung eine Barriere-Schicht angeordnet. In diesem Fall dient die Barriere-Schicht dazu, die Diffusion der Materialien der reflektierenden Beschichtung in die elektrisch leitende Beschichtung zu verhindern, und umgekehrt, um auf diese Weise eine ungewollte Veränderung der Schichtdicke der beteiligten Schichten zu vermeiden.

Die Materialien für die Barriere-Schicht sind in beiden oben beschriebenen Fällen bevorzugt ausgewählt aus der Gruppe: W, Ta, Y, Mo, Zr, Ti, Hf, Sc, deren Legierungen und/oder chemische Verbindungen, insbesondere Carbide, Nitride, Boride, Silizide, C und B₄C.

Bei einer weiteren Ausführungsform weist die elektrisch leitende Beschichtung eine Dicke zwischen 50 nm und 1000 nm auf. Die elektrisch leitende Beschichtung kann dazu verwendet werden, das Substrat vor dem schädigenden Einfluss der EUV-Strahlung zu schützen, die ansonsten ggf. zu einer Degradation des Materials des Substrats führen könnte, d.h. die elektrisch leitende Beschichtung kann als so genannte "Substrate protection layer", SPL, dienen. Zu diesem Zweck kann es günstig sein, wenn die elektrisch leitende Beschichtung eine nicht zu geringe Dicke aufweist.

Bei einer weiteren Ausführungsform weist die erste Schicht eine Dicke auf, die größer ist als die Dicke der zweiten Schicht und das Material der ersten Schicht weist eine größere Absorption für EUV-Strahlung auf als das Material der zweiten Schicht, oder umgekehrt, d.h. die zweite Schicht weist eine Dicke auf, die größer ist als die Dicke der ersten Schicht und das Material der zweiten Schicht weist eine größere Absorption für EUV-Strahlung auf als das Material der ersten Schicht. Um das Substrat vor der EUV-Strahlung zu schützen, kann es günstig sein, die Schichtdicken der ersten bzw. der zweiten Schicht geeignet zu wählen, beispielsweise indem diejenige(n) Schicht(en), deren Material eine größere Absorption für die EUV-Strahlung bei der verwendeten Wellenlänge aufweist, mit einer Dicke aufgebracht wird/werden, die größer ist als die Dicke derjenigen Schicht(en), die ein Material mit einer geringeren Absorption für die EUV-Strahlung aufweisen.

Bei den Materialien, die eine hohe Absorption aufweisen und die zum Schutz des Substrats daher ggf. mit einer größeren Dicke aufgebracht werden sollten, kann es sich beispielsweise um Materialien handeln, die ausgewählt sind aus der Gruppe umfassend: Eisen (Fe), Nickel (Ni), Kobalt (Co), Kupfer (Cu), Silber (Ag), Gold (Au), Platin (Pt), Wolfram (Wo), Chrom (Cr), Zink (Zn), Iridium (Ir) Indium (In), Zinn (Sn) und deren Legierungen und/oder Verbindungen.

Bei einer weiteren Ausführungsform weist die elektrisch leitende Beschichtung mindestens einen Abschnitt auf, der sich an dem Substrat seitlich über einen optisch genutzten Bereich der reflektierenden Beschichtung oder seitlich über die reflektierende Beschichtung hinaus erstreckt. Dies ist vorteilhaft, um die elektrisch leitende Beschichtung elektrisch zu kontaktieren. Die elektrisch leitende Beschichtung kann sich an der Oberseite des Substrats über die reflektierende Beschichtung hinaus erstrecken und/oder diese kann sich an einer Seitenfläche des Substrats über die reflektierende Beschichtung hinaus erstrecken. In dem Abschnitt, an dem sich die elektrisch leitende Beschichtung über die reflektierende Beschichtung hinaus erstreckt, kann diese beispielsweise mit Hilfe einer elektrischen Leitung kontaktiert werden, um die elektrisch leitende Beschichtung und damit das optische Element zu erden oder um ggf. einen Photostrom zu messen. Es versteht sich, dass die elektrische Kontaktierung bzw. die Erdung des optischen Elements sich vorteilhaft mit der weiter oben beschriebenen Schutzfunktion für das Substrat sowie der ggf. gewünschten Erzeugung einer vorgegebenen Schichtspannung der elektrisch leitenden Beschichtung zur Kompensation von Schichtspannungen in der reflektierenden Beschichtung kombiniert werden kann.

Bei einer weiteren Ausführungsform weist die reflektierende Beschichtung eine Mehrzahl von alternierenden Einzelschichten aus Materialien mit unterschiedlichen Brechungsindizes auf. Bei der reflektierenden Beschichtung handelt es sich in diesem Fall um eine Mehrlagen-Beschichtung, welche alternierende Einzelschichten aus typischer Weise zwei unterschiedlichen Materialien aufweist. Die Art der Materialien und die Dicken der Einzelschichten sind so gewählt, dass die reflektierende Beschichtung bei einer vorgegebenen Betriebswellenlänge, beispielsweise im EUV-Wellenlängenbereich, eine möglichst große Reflektivität aufweist. Liegt die Betriebswellenlänge bei ca. 13,5 nm, so bestehen die Einzelschichten üblicherweise aus Molybdän und Silizium. Das Substrat ist in diesem Fall typischer Weise aus einem so genannten Nullausdehnungsmaterial gebildet, welches einen niedrigen thermischen Ausdehnungskoeffizienten aufweist, beispielsweise aus Zerodur®, Clearceram® oder ULE®. Die Mehrlagen-Beschichtung ist typischer Weise zur Reflexion von unter normalem Einfall auftreffender EUV-Strahlung ausgebildet, d.h. für EUV-Strahlung, die unter Einfallswinkeln von typischer Weise weniger als ca. 45° zur Flächen-Normalen auf die reflektierende Beschichtung auftrifft.

Alternativ zur Verwendung einer Mehrlagen-Beschichtung, die für unter normalem Einfall auftreffende EUV-Strahlung optimiert ist, kann auch eine reflektierende Beschichtung verwendet werden, die für die Reflexion von unter streifendem Einfall auftreffende EUV-Strahlung ausgebildet bzw. optimiert ist. Unter streifendem Einfall von EUV-Strahlung wird typischer Weise ein Einfall von EUV-Strahlung unter einem Einfallswinkel von typischer Weise mehr als ca. 60° zur Flächennormalen der Oberfläche des optischen Elements bzw. der reflektierenden Beschichtung verstanden. Eine reflektierende Beschichtung, die für streifenden Einfall ausgebildet ist, weist typischer Weise ein Maximum der Reflektivität bei mindestens einem Einfallswinkel auf, der größer als 60° ist. Eine derartige reflektierende Beschichtung weist typischer Weise mindestens eine Schicht aus einem Material auf, das eine geringe Brechzahl und eine geringe Absorption für die unter streifendem Einfall auftreffende EUV-Strahlung aufweist. Die reflektierende Beschichtung bzw. die reflektierende Schicht kann ein metallisches Material enthalten bzw. aus einem metallischen Material gebildet sein, beispielsweise aus Mo, Ru oder Nb.

Sowohl reflektierende Beschichtungen, die für streifenden Einfall optimiert sind als auch reflektierende Beschichtungen, die für senkrechten Einfall optimiert sind, können funktionelle Schichten enthalten, beispielsweise Barriere-Schichten zur Verhinderung von Diffusion, sowie eine Deckschicht ("capping layer") zum Schutz der reflektierenden Beschichtung vor Einflüssen aus der Umgebung. Die reflektierende Beschichtung kann auch eine Haftvermittlerschicht zur Verbesserung der Haftung der reflektierenden Beschichtung auf der elektrisch leitfähigen Beschichtung aufweisen.

Bei einer weiteren Ausführungsform ist zwischen der elektrisch leitenden Beschichtung und dem Substrat mindestens eine Schutzschicht zum Schutz des Substrats vor EUV-Strahlung angebracht. Wie weiter oben beschrieben wurde, kann die elektrisch leitfähige Beschichtung ggf. selbst als Schutzschicht dienen, um das Substrat vor der auftreffenden EUV-Strahlung zu schützen. Sofern dies nur teilweise gelingt, kann zwischen der elektrisch leitfähigen Beschichtung und dem Substrat zusätzlich eine Schutzschicht aufgebracht werden. Die Schutzschicht besteht typischer Weise wiederum aus einem leitfähigen Material, beispielsweise aus: Eisen (Fe), Nickel (Ni), Kobalt (Co), Kupfer (Cu), Silber (Ag), Gold (Au), Platin (Pt), Wolfram (Wo), Chrom (Cr), Zink (Zn), Iridium (Ir), Indium (In), Zinn (Sn) und deren Legierungen und/oder Verbindungen.

Die Erfindung betrifft auch eine optische Anordnung, insbesondere ein EUV-Lithographiesystem, umfassend: mindestens ein optisches Element wie weiter oben beschrieben ist. Bei dem optischen Element kann es sich beispielsweise um einen EUV-Spiegel einer EUV-Lithographieanlage handeln, der zur Reflexion von EUV-Strahlung ausgebildet ist.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ausführungsbeispiele sind in der schematischen Zeichnung dargestellt und werden in der nachfolgenden Beschreibung erläutert. Es zeigt
- Fig. 1: eine schematische Darstellung einer EUV-Lithographieanlage,
- Fig. 2: eine schematische Darstellung eines reflektierenden optischen Elements mit einer elektrisch leitenden Beschichtung gemäß einem Vergleichsbeispiel, die aus einer ersten, unter einer Zugspannung stehenden Schicht besteht,
- Fig. 3: eine schematische Darstellung analog zu Fig. 2, bei der die elektrisch leitende Beschichtung eine zweite, unter einer Druckspannung stehende Schicht aufweist, welche die Zugspannung der ersten Schicht kompensiert, sowie
- Fig. 4: eine schematische Darstellung analog zu Fig. 3, bei der sich die elektrisch leitende Beschichtung an der Oberseite des Substrats seitlich über die reflektierende Beschichtung hinaus erstreckt.

In der folgenden Beschreibung der Zeichnungen werden für gleiche bzw. funktionsgleiche Bauteile identische Bezugszeichen verwendet.

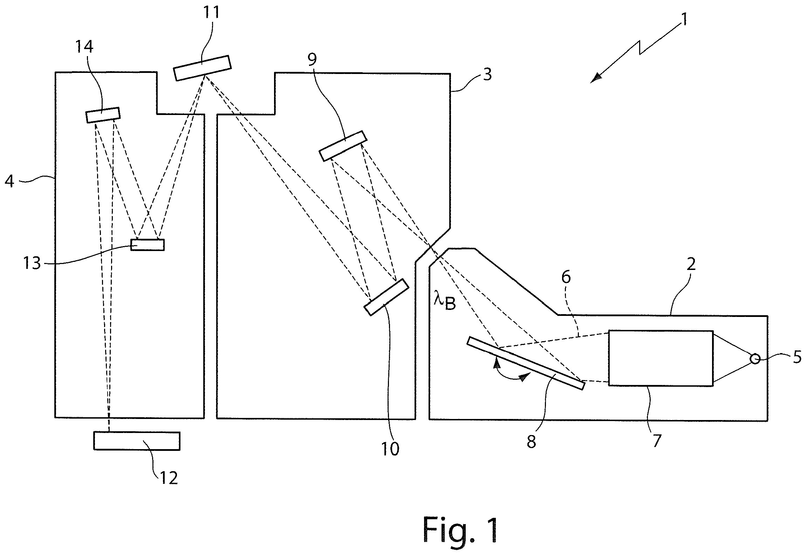

In Fig. 1 ist schematisch ein EUV-Lithographiesystem in Form einer Projektionsbelichtungsanlage 1 für die EUV-Lithographie gezeigt. Die Projektionsbelichtungsanlage 1 weist ein Strahlformungssystem 2, ein Beleuchtungssystem 3 und ein Projektionssystem 4 auf, die in separaten Vakuum-Gehäusen untergebracht und aufeinander folgend in einem von einer EUV-Lichtquelle 5 des Strahlformungssystems 2 ausgehenden Strahlengang 6 angeordnet sind. Als EUV-Lichtquelle 5 kann beispielsweise eine Plasmaquelle oder ein Synchrotron dienen. Die aus der Lichtquelle 5 austretende Strahlung im Wellenlängenbereich zwischen ca. 5 nm und ca. 20 nm wird zunächst in einem Kollimator 7 gebündelt. Mit Hilfe eines nachfolgenden Monochromators 8 wird durch Variation des Einfallswinkels, wie durch einen Doppelpfeil angedeutet, die gewünschte Betriebswellenlänge λ_{B} herausgefiltert, die im vorliegenden Beispiel bei ca. 13,5 nm liegt. Der Kollimator 7 und der Monochromator 8 sind als reflektive optische Elemente ausgebildet.

Die im Strahlformungssystem 2 im Hinblick auf Wellenlänge und räumliche Verteilung behandelte Strahlung wird in das Beleuchtungssystem 3 eingeführt, welches ein erstes und zweites reflektives optisches Element 9, 10 aufweist. Die beiden reflektiven optischen Elemente 9, 10 leiten die EUV-Strahlung auf eine Photomaske 11 als weiterem reflektiven optischen Element, welches eine Struktur aufweist, die mittels des Projektionssystems 4 in verkleinertem Maßstab auf einen Wafer 12 abgebildet wird. Hierzu sind im Projektionssystem 4 ein drittes und viertes reflektives optisches Element 13, 14 vorgesehen.

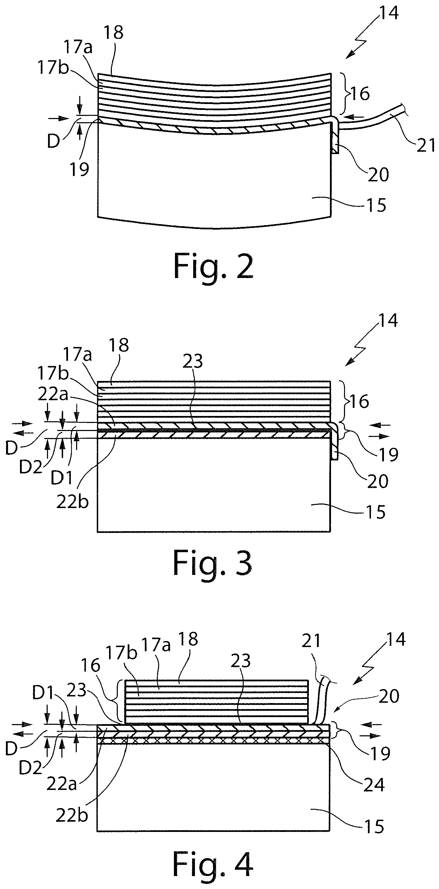

Nachfolgend wird anhand von Fig. 2 bis Fig. 4 beispielhaft das Design des vierten optischen Elements 14 näher beschrieben; das erste bis dritte optische Element 11, 12, 13 weisen ein entsprechendes Design auf. Das (vierte) optische Element 14 weist ein Substrat 15 aus einem Material mit einem niedrigen thermischen Ausdehnungskoeffizienten auf, der typischer Weise bei weniger als 100 ppb/K bei 22°C bzw. über einen Temperaturbereich von ca. 5°C bis ca. 35°C liegt. Ein Material, welches diese Eigenschaften aufweist, ist mit Titandioxid dotiertes Silikat- bzw. Quarzglas, das typischer Weise einen Silikatglasanteil von mehr als 90 % aufweist. Ein solches auf dem Markt erhältliches Silikatglas wird von der Fa. Corning Inc. unter dem Handelsnamen ULE® (Ultra Low Expansion glass) vertrieben. Eine weitere Materialgruppe, welche einen sehr geringen thermischen Ausdehnungskoeffizienten aufweist, sind Glaskeramiken, bei denen das Verhältnis der Kristallphase zur Glasphase so eingestellt wird, dass sich die thermischen Ausdehnungskoeffizienten der unterschiedlichen Phasen nahezu aufheben. Solche Glaskeramiken werden z.B. unter den Handelsnamen Zerodur® von der Fa. Schott AG bzw. unter dem Handelsnamen Clearceram® von der Fa. Ohara Inc. angeboten.

Auf das Substrat 15 ist eine reflektierende Beschichtung 16 aufgebracht, die eine Mehrzahl von Einzelschichten 17a, 17b aufweist, die aus unterschiedlichen Materialien bestehen. Im vorliegenden Fall bestehen die Einzelschichten abwechselnd aus Materialien mit unterschiedlichen Brechungsindizes. Liegt die Betriebswellenlänge λ_{B} wie im vorliegenden Beispiel bei ca. 13,5 nm, so bestehen die Einzelschichten üblicherweise aus Molybdän und Silizium. Andere Materialkombinationen wie z.B. Molybdän und Beryllium, Ruthenium und Beryllium oder Lanthan und B₄C sind ebenfalls möglich. Zusätzlich zu den beschriebenen Einzelschichten kann die reflektierende Beschichtung 16 auch Zwischenschichten bzw. Barriere-Schichten zur Verhinderung von Diffusion beinhalten. Auf die Darstellung solcher Hilfsschichten in den Figuren wurde verzichtet.

Die reflektierende Beschichtung 16 weist auch eine Deckschicht 18 auf, um die darunter liegenden Einzelschichten 17a, 17b zu schützen und beispielsweise deren Oxidation zu verhindern. Die Deckschicht 18 besteht im vorliegenden Beispiel aus Ruthenium. Es versteht sich, dass auch andere Materialien, insbesondere metallische Materialien wie Rhodium, Palladium, Platin, Iridium, Niobium, Vanadium, Chrom, Zink oder Zinn als Deckschicht-Materialien verwendet werden können. Es versteht sich ebenfalls, dass die Deckschicht 18 für die EUV-Strahlung 6 durchlässig ist.

Alternativ zu der in Fig. 2 gezeigten reflektierenden Beschichtung 16, die für unter normalem Einfall auftreffende EUV-Strahlung 6 ausgebildet ist, kann die reflektierende Beschichtung 16 für unter streifendem Einfall auftreffende EUV-Strahlung 6 ausgebildet bzw. optimiert sein. In diesem Fall kann die reflektierende Beschichtung 16 ggf. nur eine einzige Schicht aufweisen, die beispielsweise aus einem metallischen Material, insbesondere aus Mo, Ru oder Nb gebildet sein kann.

Bei dem in Fig. 2 gezeigten Vergleichsbeispiel ist zwischen der reflektierenden Beschichtung 16 und dem Substrat 15 eine elektrisch leitende Beschichtung 19 angeordnet, die nur aus einer einzigen Schicht aus einem Edelmetall, im gezeigten Beispiel aus Gold, besteht. Die elektrisch leitende Beschichtung 19 weist bei dem in Fig. 2 gezeigten Vergleichsbeispiel einen Abschnitt auf, der sich an einer Seitenfläche des Substrats 15 erstreckt, um die elektrisch leitende Beschichtung 19 elektrisch kontaktieren zu können. Die elektrische Kontaktierung erfolgt bei dem in Fig. 2 gezeigten Vergleichsbeispiel durch eine elektrische Leitung 21, die beispielsweise mit Masse-Potential verbunden sein kann, um das optische Element 14 zu erden. Die Leitung 21 kann auch dazu dienen, um einen Photostrom, der durch die Bestrahlung mit der EUV-Strahlung 6 in der reflektierenden Beschichtung 16 erzeugt wird, von dem optischen Element 14 abzuleiten und den Photostrom beispielsweise in einem Ladungsverstärker zu messen.

Die elektrisch leitende Beschichtung 19 wird mit Hilfe von herkömmlichen Beschichtungsverfahren hergestellt, und zwar typischer Weise durch "Physical Vapor Deposition"(PVD)-Verfahren wie z.B. thermisches Verdampfen oder Elektronenstrahl-Verdampfen, lonenstrahl- bzw. Magnetronsputtern oder Pulsed Laser Deposition, oder Beschichtungsverfahren, die auf "Chemical Vapor Deposition" (CVD) beruhen. Beim Aufbringen der elektrisch leitenden Beschichtung 19 wird eine Schichtspannung erzeugt, die bei dem in Fig. 2 gezeigten Vergleichsbeispiel, bei dem Gold als Material für die elektrisch leitende Beschichtung 19 verwendet wird, zu einer Zugspannung in der elektrisch leitenden Beschichtung führt, wie in Fig. 2 durch zwei seitliche Pfeile an der elektrisch leitenden Beschichtung 19 angedeutet ist.

Die Zugspannung hat bei den typischer Weise für die elektrisch leitende Beschichtung 19 verwendeten Dicke D von typischer Weise zwischen ca. 50 nm und ca. 1000 nm, im gezeigten Vergleichsbeispiel bei ca. 300 nm, zur Folge, dass sich das Substrat 15 verbiegt, so dass dieses an seiner der reflektierenden Beschichtung 16 zugewandten Seite eine konkave Krümmung ausbildet, die in Fig. 2 zur Verdeutlichung stark übertrieben dargestellt ist. Die elektrisch leitende Schicht 19 führt somit zu einer Abweichung der Oberflächenform des optischen Elements 14 von einer Soll-Oberflächenform (Soll-Passe), bei der es sich bei dem in Fig. 2 gezeigten Vergleichsbeispiel um eine plane Oberflächenform handelt. Die Abweichung von der Soll-Oberflächenform führt zu Aberrationen des optischen Elements 14 beim Betrieb in der EUV-Lithographieanlage 1. Um die unerwünschte Deformation des Substrats 15 und damit der Oberflächenform des optischen Elements 14 zu vermeiden, weist bei dem in Fig. 3 dargestellten Beispiel die elektrisch leitende Beschichtung 19 eine erste, unter einer Zugspannung stehende Schicht 22a und eine zweite, unter einer Druckspannung stehende Schicht 22b auf. Die erste, unter der Zugspannung stehende Schicht 22a und/oder die zweite unter Druckspannung stehende Schicht 22b können beispielsweise aus einem Material gebildet sein, welches ausgewählt ist aus der Gruppe umfassend: Silber, Kupfer, Gold, Aluminium, Rhodium, Iridium, Wolfram, Molybdän, Cobalt, Nickel, Ruthenium, Indium, Osmium, Eisen, Platin, Palladium, Chrom, Tantal, Titan, Zr, Re. Sowohl die erste als auch die zweite Schicht 22a, 22b der elektrisch leitenden Beschichtung 19 können an Stelle eines metallischen Materials z.B. auch aus einer (elektrisch leitenden) Legierung gebildet sein. Ob die erste bzw. zweite Schicht 22a, 22b unter einer Zugspannung oder einer Druckspannung steht, hängt neben dem verwendeten Material auch von dem Beschichtungsverfahren ab, mit dem das jeweilige Material aufgebracht wird. Im gezeigten Beispiel ist die erste Schicht 22a, die aus Gold besteht, durch Elektronenstrahl-Verdampfen aufgebracht, wodurch sich in der ersten Schicht 22a eine Zugspannung ausbildet. Die zweite Schicht 22b besteht im gezeigten Beispiel aus Ruthenium und wurde durch Sputtern hergestellt, wodurch sich in dem Ruthenium-Material der zweiten Schicht 22b eine Druckspannung ausbildet.

Bei dem in Fig. 3 gezeigten Beispiel sind die Zugspannung der ersten Schicht 22a und die Druckspannung der zweiten Schicht 22b so gewählt, dass die resultierende Schichtspannung der elektrisch leitenden Beschichtung 19 im Wesentlichen verschwindet, so dass die plane Soll-Oberflächenform des Substrats 15 und somit auch der reflektierenden Oberfläche des optischen Elements 14 erzeugt wird.

Hierbei wird ausgenutzt, dass die unter Druckspannung stehende zweite Schicht 22b einen Verbiegung des Substrats erzeugt, welche der Verbiegung durch die unter Zugspannung stehenden ersten Schicht 22a entgegen gesetzt gerichtet ist, da die unter Druckspannung stehende zweite Schicht 22b eine konvexe Krümmung des Substrats 15 bewirkt. Um die Kompensation der Schichtspannungen der elektrisch leitenden Beschichtung 19 zu erzeugen, sind die Schichtmaterialien und die Dicken der ersten und der zweiten Schicht 22a, 22b geeignet aneinander angepasst.

Wie in Fig. 3 ebenfalls zu erkennen ist, ist zwischen der unter Zugspannung stehenden ersten Schicht 22a und der unter Druckspannung stehenden zweiten Schicht 22b eine Barriere-Schicht 23 angeordnet, die eine Diffusion des Materials der ersten Schicht 22a in die zweite Schicht 22b (und umgekehrt) im Wesentlichen verhindern soll. Die Barriere-Schicht 23 weist typischer Weise eine so geringe Dicke (z.B. von weniger als 1 nm) auf, dass deren Schichtspannung auf die elektrisch leitende Beschichtung 19 praktisch vernachlässigbar ist. Es versteht sich aber, dass erforderlichenfalls der Einfluss der Zug- bzw. der Druckspannung der Barriere-Schicht 23 auf die resultierende Schichtspannung der elektrisch leitenden Beschichtung 19 berücksichtigt werden muss. Es versteht sich ebenfalls, dass die elektrisch leitende Beschichtung 19 ggf. mehr als eine unter einer Zugspannung stehende Schicht 22a und eine unter einer Druckspannung stehende Schicht 22b sowie ggf. weitere Barriere-Schichten aufweisen kann. Das Material der Barriere-Schicht 23 kann beispielsweise ausgewählt sein aus der Gruppe umfassend: W, Ta, Y, Mo, Zr, Ti, Hf, Sc, deren Legierungen und/oder Verbindungen, insbesondere Carbide, Nitride, Boride, Silizide, C und B₄C.

An Stelle einer im Wesentlichen vollständigen Kompensation der Schichtspannungen der unter Zug- bzw. unter Druckspannung stehenden Schichten 22a, 22b ist es auch möglich, mit Hilfe der elektrisch leitenden Beschichtung 19 eine vorgegebene resultierende Schichtspannung zu erzeugen, die genutzt werden kann, um Schichtspannungen, die in der reflektierenden Beschichtung 16 durch den Beschichtungsvorgang auftreten, ganz oder teilweise zu kompensieren. Um ggf. lokal variierende Schichtspannungen in der reflektierenden Beschichtung 16 kompensieren zu können, kann die elektrisch leitende Beschichtung 19 eine ortsabhängige Variation der Dicke der einzelnen unter Zug- bzw. unter Druckspannung stehenden Schichten 22a, 22b aufweisen. Eine solche, ggf. ortsabhängige Variation der Schichtdicken und/oder der verwendeten Schichtmaterialien bzw. der Zusammensetzung der Schichten 22a, 22b kann ggf. auch aus anderen Gründen erfolgen, beispielweise um einen Schutz gegen den Einfluss der EUV-Strahlung 6 auf das Substrat 15 zu erreichen.

Zum Schutz des Substrats 15 vor der EUV-Strahlung 6 sollten diejenigen Schichten 22a, 22b der elektrisch leitenden Beschichtung 19, die eine hohe Absorption für die EUV-Strahlung 6 aufweisen, idealer Weise eine größere Dicke aufweisen als diejenigen Schichten 22a, 22b, die eine geringe Absorption für die EUV-Strahlung 6 aufweisen. Bei dem in Fig. 2 gezeigten Beispiel kann die erste Schicht 22a, die aus Gold besteht, beispielsweise eine Dicke D1 aufweisen, die größer ist als die Dicke D2 der zweiten Schicht 22b, die aus Ruthenium besteht, da Gold eine größere Absorption für die EUV-Strahlung 6 als Ruthenium aufweist. Materialien, die zum Schutz des Substrats 15 mit einer größeren Dicke aufgebracht werden sollten, können beispielsweise ausgewählt sein aus der Gruppe umfassend: Fe, Ni, Co, Cu, Ag, Au, Pt, Wo, Cr, Zn, Ir, In, Sn und deren Legierungen und/oder Verbindungen.

Bei dem in Fig. 3 gezeigten Beispiel weist die elektrisch leitfähige Beschichtung 19 wie bei dem in Fig. 2 gezeigten Vergleichsbeispiel einen Abschnitt 20 auf, der sich an dem Substrat 15 seitlich über die reflektierende Beschichtung 16 hinaus erstreckt, und zwar wie in Fig. 2 entlang einer Seitenfläche des Substrats 15. Der überstehende Abschnitt 20 dient wie in Fig. 2 der elektrischen Kontaktierung der elektrisch leitenden Beschichtung 19. An Stelle des Abschnitts 20 der elektrisch leitenden Beschichtung 19 kann bei dem in Fig. 3 gezeigten Beispiel auch nur ein Teil, beispielsweise eine einzelne der Schichten 22a, 22b an der Seitenfläche des Substrats 15 über die reflektierende Beschichtung 16 überstehen, da in diesem Bereich der Einfluss der Zug- bzw. der Druckspannung auf die Oberflächenform des optischen Elements 14 typischer Weise geringer ist als an der Oberseite des Substrats 15. In der Regel ist es jedoch günstiger, wenn die gesamte (spannungskompensierte) elektrisch leitfähige Beschichtung 19 den überstehenden Abschnitt 20 bildet, wie dies in Fig. 3 dargestellt ist.

Fig. 4 zeigt ein weiteres Beispiel eines optischen Elements 14 welches sich von dem in Fig. 3 gezeigten optischen Element 14 dadurch unterscheidet, dass die elektrisch leitende Beschichtung 19 einen seitlich über die reflektierende Beschichtung 16 überstehenden Abschnitt 20 aufweist, der nicht an der Seitenfläche des Substrats 15, sondern an dessen Oberseite gebildet ist. Wie in Fig. 4 zu erkennen ist, kann in diesem Fall die elektrisch leitende Beschichtung 19 an der Oberseite des Substrats 15 mit einer elektrischen Leitung 21 kontaktiert werden, um das optische Element 14 zu erden sowie um ggf. einen Photostrom von diesem abzuleiten.

Bei dem in Fig. 4 gezeigten Beispiel ist zudem eine Barriere-Schicht 23 zwischen der reflektierenden Beschichtung 16 und der elektrisch leitenden Beschichtung 19 gebildet, um die Diffusion von Material aus der reflektierenden Beschichtung 16 in die elektrisch leitende Beschichtung 19 (und umgekehrt) zu verhindern. Die Barriere-Schicht 23 besteht im gezeigten Beispiel aus Kohlenstoff, kann aber auch aus einem anderen Material, beispielsweise aus W, Ta, B₄C oder Mo gebildet sein.

Bei dem in Fig. 4 gezeigten Beispiel ist zwischen der elektrisch leitenden Beschichtung 19 und dem Substrat 15 eine Schutzschicht 24 gebildet, die zum Schutz des Substrats 15 vor der EUV-Strahlung 6 dient. Diese ist ggf. erforderlich, falls die elektrisch leitende Beschichtung 19 die EUV-Strahlung 6 nicht ausreichend absorbiert, so dass diese zum Substrat 15 gelangen kann. Die Schutzschicht 24 besteht wiederum typischer Weise aus einem leitfähigen Material, beispielsweise aus: Eisen (Fe), Nickel (Ni), Kobalt (Co), Kupfer (Cu), Silber (Ag), Gold (Au), Platin (Pt), Wolfram (Wo), Chrom (Cr), Zink (Zn), Iridium (Ir), Indium (In), Zinn (Sn) und deren Legierungen und/oder Verbindungen. Die Schichtspannung der Schutzschicht 24 kann ggf. unberücksichtigt bleiben, diese kann aber ggf. auch bei der weiter oben beschriebenen Kompensation der Schichtspannungen berücksichtigt werden.

Mit der weiter oben beschriebenen elektrisch leitenden Beschichtung 19 kann eine Erdung des optischen Elements 14 ohne eine Verschlechterung von dessen optischen Eigenschaften erfolgen. Zudem kann die elektrisch leitende Beschichtung 19 mit einer definierten Vorspannung beaufschlagt werden bzw. zum Ableiten eines Photostroms verwendet werden. Die elektrisch leitende Beschichtung 19 kann insbesondere auch zum Schutz des Substrats 15 vor der EUV-Strahlung 6 dienen.

## Patentansprüche

1. Optisches Element (14) für die EUV-Lithographie umfassend:
ein Substrat (15),
eine auf das Substrat (15) aufgebrachte reflektierende Beschichtung (16), sowie
eine sich zwischen dem Substrat (15) und der reflektierenden Beschichtung (16) erstreckende elektrisch leitende Beschichtung (19),
wobei die elektrisch leitende Beschichtung (19) mindestens einen Abschnitt (20) aufweist, der sich an dem Substrat (15) seitlich über die reflektierende Beschichtung (16) hinaus erstreckt,
**dadurch gekennzeichnet,**
**dass** die elektrisch leitende Beschichtung (19) mindestens eine erste, unter Zugspannung stehende Schicht (22a) und mindestens eine zweite, unter Druckspannung stehende Schicht (22b) aufweist.

2. Optisches Element nach Anspruch 1, bei dem die erste und/oder die zweite Schicht (22a, 22b) aus einem metallischen Material oder einer metallischen Legierung gebildet ist/sind.

3. Optisches Element nach Anspruch 1 oder 2, bei dem das Material der ersten Schicht (22a) und/oder das Material der zweiten Schicht (22b) ausgewählt ist aus der Gruppe umfassend: Silber, Kupfer, Gold, Aluminium, Rhodium, Iridium, Wolfram, Molybdän, Kobalt, Nickel, Ruthenium, Indium, Osmium, Eisen, Platin, Palladium, Chrom , Tantal, Titan, Zr, Re und deren Legierungen.

4. Optisches Element nach einem der vorhergehenden Ansprüche, bei dem die elektrisch leitende Beschichtung (19) mindestens eine Barriere-Schicht (23) aufweist, die zwischen der ersten Schicht (22a) und der zweiten Schicht (22b) angeordnet ist.

5. Optisches Element nach einem der vorhergehenden Ansprüche, bei dem zwischen der reflektierenden Beschichtung (16) und der elektrisch leitenden Beschichtung (19) mindestens eine Barriere-Schicht (23) angeordnet ist.

6. Optisches Element nach Anspruch 4 oder 5, bei dem das Material der Barriere-Schicht (23) ausgewählt ist aus der Gruppe umfassend: W, Ta, Y, Mo, Zr, Ti, Hf, Sc, deren Legierungen und/oder Verbindungen, insbesondere Carbide, Nitride, Boride, Silizide, C und B₄C.

7. Optisches Element nach einem der vorhergehenden Ansprüche, bei dem die elektrisch leitende Beschichtung (19) eine Dicke (D) zwischen 50 nm und 1000 nm aufweist.

8. Optisches Element nach einem der vorhergehenden Ansprüche, bei dem die erste Schicht (22a) eine Dicke (D1) aufweist, die größer ist als die Dicke (D2) der zweiten Schicht (22b) und bei dem das Material der ersten Schicht (22a) eine größere Absorption für EUV-Strahlung (6) aufweist als das Material der zweiten Schicht (22b), oder umgekehrt.

9. Optisches Element nach einem der vorhergehenden Ansprüche, bei dem die reflektierende Beschichtung (16) eine Mehrzahl von alternierenden Einzelschichten (17a, 17b) aus Materialien mit unterschiedlichen Brechungsindizes aufweist.

10. Optisches Element nach einem der vorhergehenden Ansprüche, bei dem zwischen der elektrisch leitenden Beschichtung (19) und dem Substrat (15) mindestens eine Schutzschicht (24) zum Schutz des Substrats (15) vor EUV-Strahlung (6) angebracht ist.

11. Optische Anordnung, insbesondere EUV-Lithographiesystem (1), umfassend: mindestens ein optisches Element (14) nach einem der vorhergehenden Ansprüche.

12. Optische Anordnung nach Anspruch 11, weiter umfassend: eine elektrische Leitung (21) zur Kontaktierung des mindestens einen Abschnitts (20), der sich an dem Substrat (15) seitlich über die reflektierende Beschichtung (16) hinaus erstreckt.

## Claims

1. Optical element (14) for EUV lithography, comprising:
a substrate (15),
a reflective coating (16) applied on the substrate (15), and
an electrically conductive coating (19) extending between the substrate (15) and the reflective coating (16),
wherein the electrically conductive coating (19) has at least one section (20) that extends on the substrate (15) laterally beyond the reflective coating (16),
**characterized**
**in that** the electrically conductive coating (19) has at least one first layer (22a) under tensile stress and at least one second layer (22b) under compressive stress.

2. Optical element according to Claim 1, wherein the first and/or the second layer (22a, 22b) are/is formed from a metallic material or a metallic alloy.

3. Optical element according to Claim 1 or 2, wherein the material of the first layer (22a) and/or the material of the second layer (22b) are/is selected from the group comprising: silver, copper, gold, aluminium, rhodium, iridium, tungsten, molybdenum, cobalt, nickel, ruthenium, indium, osmium, iron, platinum, palladium, chromium, tantalum, titanium, Zr, Re and alloys thereof.

4. Optical element according to any of the preceding claims, wherein the electrically conductive coating (19) has at least one barrier layer (23) that is arranged between the first layer (22a) and the second layer (22b).

5. Optical element according to any of the preceding claims, wherein at least one barrier layer (23) is arranged between the reflective coating (16) and the electrically conductive coating (19).

6. Optical element according to Claim 4 or 5, wherein the material of the barrier layer (23) is selected from the group comprising: W, Ta, Y, Mo, Zr, Ti, Hf, Sc, alloys and/or compounds thereof, in particular carbides, nitrides, borides, silicides, C and B₄C.

7. Optical element according to any of the preceding claims, wherein the electrically conductive coating (19) has a thickness (D) of between 50 nm and 1000 nm.

8. Optical element according to any of the preceding claims, wherein the first layer (22a) has a thickness (D1) that is greater than the thickness (D2) of the second layer (22b), and wherein the material of the first layer (22a) has a greater absorption for EUV radiation (6) than the material of the second layer (22b), or vice-versa.

9. Optical element according to any of the preceding claims, wherein the reflective coating (16) has a plurality of alternating individual layers (17a, 17b) composed of materials having different refractive indices.

10. Optical element according to any of the preceding claims, wherein at least one protective layer (24) for protecting the substrate (15) against EUV radiation (6) is mounted between the electrically conductive coating (19) and the substrate (15).

11. Optical assembly, in particular EUV lithography system (1), comprising: at least one optical element (14) according to any of the preceding claims.

12. Optical assembly according to Claim 11, further comprising: an electrical line (21) for contacting the at least one section (20) that extends on the substrate (15) laterally beyond the reflective coating (16).

## Revendications

1. Élément optique (14) destiné à la lithographie EUV, comprenant :
un substrat (15),
un revêtement réfléchissant (16) appliqué sur le substrat (15), et
un revêtement électriquement conducteur (19) s'étendant entre le substrat (15) et le revêtement réfléchissant (16),
le revêtement électriquement conducteur (19) comportant au moins une portion (20) qui s'étend sur le substrat (15) latéralement au-delà du revêtement réfléchissant (16),
**caractérisé en ce que**
le revêtement électriquement conducteur (19) comporte au moins une première couche (22a) soumise à une contrainte de traction et au moins une deuxième couche (22b) soumise à une contrainte de compression.

2. Élément optique selon la revendication 1, dans lequel la première et/ou la deuxième couche (22a, 22b) sont formées à partir d'un matériau métallique ou d'un alliage métallique.

3. Élément optique selon la revendication 1 ou 2, dans lequel le matériau de la première couche (22a) et/ou le matériau de la deuxième couche (22b) sont choisis dans le groupe comprenant : l'argent, le cuivre, l'or, l'aluminium, le rhodium, l'iridium, le tungstène, le molybdène, le cobalt, le nickel, le ruthénium, l'indium, l'osmium, le fer, le platine, le palladium, le chrome, le tantale, le titane, le Zr, le Re et leurs alliages.

4. Élément optique selon l'une des revendications précédentes, dans lequel le revêtement électriquement conducteur (19) comporte au moins une couche barrière (23) qui est disposée entre la première couche (22a) et la deuxième couche (22b).

5. Élément optique selon l'une des revendications précédentes, dans lequel au moins une couche barrière (23) est disposée entre le revêtement réfléchissant (16) et le revêtement électriquement conducteur (19).

6. Élément optique selon la revendication 4 ou 5, dans lequel le matériau de la couche barrière (23) est choisi dans le groupe comprenant : W, Ta, Y, Mo, Zr, Ti, Hf, Sc, leurs alliages et/ou composés, en particulier les carbures, les nitrures, les borures, les siliciures, C et B₄C.

7. Élément optique selon l'une des revendications précédentes, dans lequel le revêtement électriquement conducteur (19) a une épaisseur (D) comprise entre 50 nm et 1000 nm.

8. Élément optique selon l'une des revendications précédentes, dans lequel la première couche (22a) a une épaisseur (D1) qui est supérieure à l'épaisseur (D2) de la deuxième couche (22b) et dans lequel le matériau de la première couche (22a) présente une absorption plus importante pour le rayonnement EUV (6) que le matériau de la deuxième couche (22b), ou vice versa.

9. Élément optique selon l'une des revendications précédentes, dans lequel le revêtement réfléchissant (16) comporte une pluralité de couches individuelles alternées (17a, 17b) en matériaux de différents indices de réfraction.

10. Élément optique selon l'une des revendications précédentes, dans lequel au moins une couche de protection (24) destinée à protéger le substrat (15) contre le rayonnement EUV (6) est appliquée entre le revêtement électriquement conducteur (19) et le substrat (15).

11. Ensemble optique, notamment système de lithographie EUV (1), comprenant : au moins un élément optique (14) selon l'une des revendications précédentes.

12. Ensemble optique selon la revendication 11, comprenant en outre : une ligne électrique (21) destinée à venir en contact avec l'au moins une portion (20) qui s'étend sur le substrat (15) latéralement au-delà du revêtement réfléchissant (16).
